(19) Europäisches Patentamt
European Patent Office
Office européen des brevets

(11) EP 4 151 410 A1

(12) EUROPEAN PATENT APPLICATION

(43) Date of publication:
**22.03.2023 Bulletin 2023/12**

(21) Application number: **21306289.6**

(22) Date of filing: **17.09.2021**

(51) International Patent Classification (IPC):
***B33Y 70/00*** *(2015.01)* ***G03F 7/00*** *(2006.01)*
***G03F 7/029*** *(2006.01)* ***G03F 7/031*** *(2006.01)*
***G03F 7/038*** *(2006.01)*

(52) Cooperative Patent Classification (CPC):
**G03F 7/029; B33Y 70/00; G03F 7/0037; G03F 7/031; G03F 7/038**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **ARKEMA FRANCE**
**92700 Colombes (FR)**

(72) Inventors:
- **REN, Kangtai**
  **EXTON, 19341 (US)**
- **PLENDERLEITH, Richard**
  **WETHERBY, LS22 7NS (GB)**
- **KLANG, Jeffrey**
  **EXTON, 19341 (US)**
- **WOLF, William**
  **EXTON, 19341 (US)**
- **ANDERSSON, Jonathan**
  **EXTON, 19341 (US)**
- **AHMARI, Ali**
  **EXTON, 19341 (US)**

(74) Representative: **Arkema Patent**
**Arkema France**
**DRD-DPI**
**420, rue d'Estienne d'Orves**
**92705 Colombes Cedex (FR)**

(54) **PHOTOSENSITIVE COMPOSITION**

(57) The present invention relates to a photosensitive composition comprising a photoinitiator component, a photoinhibitor component, a photosensitizer component, and a chain transfer agent component.

The present invention further relates to a curable composition comprising an ethylenically unsaturated compound and the photosensitive composition and a method for producing a cured product from the curable composition.



Processed by Luminess, 75001 PARIS (FR)

## Description

### Technical field

The present invention relates to a photosensitive composition comprising a photoinitiator component, photoinhibitor component, a photosensitizer component and a chain transfer agent component. The present invention further relates to a curable composition comprising an ethylenically unsaturated compound and the photosensitive composition; and to a method for producing a cured product by curing the above curable composition.

### Technical background

Photolithographic rapid prototyping (such as stereolithography) technologies typically achieve reaction confinement in depth using patterned irradiation of a photopolymerizable resin at a wavelength where the resin strongly absorbs so that a thin layer of material is solidified. Consequently, three-dimensional objects are fabricated by progressive, two-dimensional addition of material. However, these existent technologies are limited by having a slow fabrication rate and require structures to support overhanging features.

In some polymerization strategies, a monomeric resin is polymerized by irradiating a mixture of the monomeric resin and a photoinitiator at a wavelength where the photoinitiator absorbs. Activating the photoinitiator produces an activating species (e.g., a radical) that causes the monomer to polymerize in the region comprising the activating species. Some technologies provide additional control over polymerization by using both a photoinitiator and a photoinhibitor to define regions of polymerization and inhibition of polymerization. In particular, strategies have been developed in which concurrent photoinitiation and photoinhibition using two wavelengths of light provides improved control of polymerization. However, such methods are time-consuming as they necessitate irradiation with more than one wavelengths.

In addition, the fabrication of 3D-printed articles from monomeric resins, such as (meth)acrylate-based resins, with high cure speeds may cause issues such as poor resolution and layer bleeding, both negatively affecting the quality of the 3D printed article. Furthermore, high cure speed may cause high shrinkage stress which results in distortion, warpage and brittleness of the 3D printed article. To overcome these issues, the use of photoabsorbers or photoblockers makes it possible to decrease the cure speed and thus improve resolution and the quality of the article. However, such techniques require high contents of photoinitiator in combination with an optimal photoblocker, which not only increases the gelation exposure energy or critical energy (Ec) but also decreases the cure depth or depth of penetration (Dp). Ec represents the amount of energy that needs to be applied to cure a composition to a *"green state"*. By *"green state"* is meant a state at which, during printing, the liquid resin is partially cured to the point that 3D parts are strong enough to hold shape in place and allow post treatment (handling). In addition, the parts at green state usually need a post cure process to develop their mechanical properties further into end-use parts. Dp represents the depth the UV photons penetrate the composition which determines the thickness of the layer that can be printed.

Document WO 2019/164808 relates to a method of polymerization and production of polymers and particularly, to a method for producing articles using three-dimensional printing and for improving control of polymerization using a polymerization photoinhibitor having fast back reaction kinetics such as hexaarylbiimidazole compounds and bridged hexaarylbiimidazole compounds.

Document US 2016/0067921 relates to a method for three-dimensional printing adhesion reduction using photoinhibition. This method comprises: moving a build plate in a vat of liquid including a photoactive resin; creating a photoinhibition layer within the liquid directly adjacent a window of the vat by directing a first light through the window into the liquid, the first light having a first wavelength selected to produce photoinhibition; and creating a solid structure on the build plate from the photoactive resin within a photoinitiation layer of the liquid by directing a second light through the window into the liquid, where the photoinitiation layer resides between the photoinhibition layer and the build plate, and the second light has a second wavelength different than the first wavelength.

There is thus a need for a composition and a method that make it possible to efficiently provide good quality 3D printed articles having an improved resolution, without negatively affecting parameters such as the gelation exposure energy and the cure depth of the composition.

### Summary of the invention

It is a first object of the invention to provide a photosensitive composition comprising:

- a photoinitiator component;
- a photoinhibitor component;
- a photosensitizer component; and
- a chain transfer agent component.

Another object of the present invention is a curable composition comprising:

- one or more ethylenically unsaturated compounds; and
- the photosensitive composition according to the invention.

Yet another object of the present invention is a method for producing a cured product, wherein the method comprises curing the curable composition according to the invention by irradiating the curable composition.
The invention is also directed to the use of the photosensitive composition according to the invention for curing an ethylenically unsaturated compound.
The present invention enables to meet the abovementioned need. In particular, the invention provides a composition and a method which make it possible to efficiently provide good quality 3D printed articles presenting an improved resolution, without negatively affecting parameters such as the gelation exposure energy and the cure depth of the composition.
This is achieved by the photosensitive composition according to the present invention. More particularly, the combination of a photoinitiator component, a photoinhibitor component, a photosensitizer component, and a chain transfer agent component make it possible not only to obtain good quality products having an improved resolution but also to obtain such products without affecting the manufacturing process and parameters such as the gelation exposure energy and the cure depth of the composition.

## Brief description of the drawings

**Figure 1** shows the absorbance and LED emission of different compositions of Example 1 as a function of the wavelength. The absorbance and LED emission can be read on the Y-axis and the wavelength (nm) can be read on the X-axis.

**Figure 2** shows a variety of holes printed by using different curable composition of Example 2.

## Detailed description

The invention will now be described in more detail without limitation in the following description.

### Photosensitive composition

By *"photosensitive composition"* is meant a composition that reacts upon exposure to light, in particular UV, near-UV, visible, infrared or near-infrared light.
The photosensitive composition according to the invention comprises, consists of or consists essentially of:

- a photoinitiator component;
- a photoinhibitor component;
- a photosensitizer component; and
- a chain transfer component.

The photoinitiator component, the photoinhibitor component, the photosensitizer component and the chain transfer component are distinct from one another and are as defined hereinafter.
Advantageously, the mixture of the photoinitiator component and the photosensitizer component has an absorption maximum at substantially the same wavelength as that of the mixture of the photoinhibitor component and the photosensitizer component. This makes it possible to obtain good quality products using a single light source, in particular a single wavelength.
As used herein the term *"substantially the* same *wavelength"* means a wavelength that is the same as another wavelength or is higher or lower than the other wavelength by no more than 10 nm, or 8 nm or 5 nm or 4 nm or 3 nm or 2 nm or 1 nm.
An absorption maximum ($\lambda_{max}$) of a compound (or mixture of compounds) may be determined by measuring the absorbance of a dilute solution of said compound (or mixture of compounds) at different wavelengths using UV/Vis spectroscopy and plotting the curve of absorbance as a function of wavelength. The wavelength corresponding to the maximum of a peak on the curve is an absorption maximum. A curve may exhibit more than one absorption maximum.
In particular, both mixtures (mixture of photoinitiator component and photosensitizer component on one side

and mixture of photoinhibitor component and photosensitizer component on the other side) have an absorption maximum in the range of from 300 to 1000 nm, or from 320 to 450 nm, or from 350 to 420 nm, or from 360 to 410 nm.

Photoinitiator component

The photosensitive composition of the invention comprises a photoinitiator component. The photoinitiator component comprises or consists of a photoinitiator. The photoinitiator component may comprise or consist of a mixture of photoinitiators.

By *"photoinitiator"* is meant a compound that, upon irradiation with light (i.e. UV, near-UV, visible, infrared or near-infrared light) forms an initiating species (i.e. radicals and/or ions) that initiate the polymerization of a polymerizable monomer. A photoinitiator may be chemically changed after the polymerization as it has reacted with other chemical species.

As used herein, the term *"light"* is understood to refer to electromagnetic radiation in any appropriate region of the electromagnetic spectrum and is not limited to visible light. Accordingly, the term *"light"* encompasses UV, near-UV, visible, infrared or near-infrared electromagnetic radiation. As used herein, the term *"irradiation"* refers to light directed toward a surface, composition, molecule, etc., so that it contacts the surface, composition, molecule, etc.

In particular, the photoinitiator component may comprise or consist of one or more radical photoinitiators, i.e. compounds that generate radicals when exposed to radiation. Radical photoinitiators can adopt different modes of action and may be classified as Norrish Type I and/or Norrish Type II photoinitiators.

As used herein, the term *"activity"* with reference to Norrish Type I and/or Norrish Type II activity is intended to relate to Norrish photoinitiation and analogous reactions. For instance, a photoinitiator having Norrish Type I activity within the scope of this invention is a photoinitiator characterized by a cleavage reaction into two radical fragments of the original photoinitiator on exposure to light. For an photoinitiator having Norrish Type II activity, exposure to light causes the abstraction of an atom, such as hydrogen, to generate the radical. A photoinitiator may have both Norrish Type I activity and Norrish Type II activity, for example when the photoinitiator comprises two distinct moieties each having a different mode of action.

The photoinitiator component may comprise or consist of one or more photoinitiators having Norrish Type I activity, one or more photoinitiators having Norrish Type II activity, one or more photoinitiators having both Norrish Type I activity and Norrish Type II activity, and combinations thereof. When the photoinitiator component comprises a mixture of photoinitiators, the photoinitiators may have the same or different Norrish Type activities.

In particular, the photoinitiator component may comprise or consist of one or more photoinitiators having Norrish Type I activity and optionally Norrish Type II activity.

In one embodiment, the photoinitiator component comprises or consists of one or more phosphine oxides. The photoinitiator component may comprise or consist of a blend of phosphine oxides. The photoinitiator component may comprise or consist of a blend of a phosphine oxide and a photoinitiator other than a phosphine oxide.

As used herein, the term *"phosphine oxide"* refers to a compound comprising a group of the following formula (I):

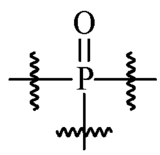

(I).

In particular, the photoinitiator component may comprise or consist of a phosphine oxide photoinitiator having Norrish Type I activity.

The photoinitiator component may comprise or consist of an acyl phosphine oxide, in particular a mono-acyl phosphine oxide or a di-acyl phosphine oxide, more particularly a mono-acyl phosphine oxide. The use of a mono-acyl phosphine oxide can be advantageous due to their greater solubility when compared to the generally larger di-acyl analogues.

As used herein, the term *"mono-acyl phosphine oxide"* means a compound comprising a group of the following formula (II):

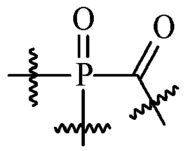

(II)

there being no other -C(=O)- group directly bound to the phosphorous atom.

In particular, a mono-acyl phosphine oxide may correspond to the following formula (III):

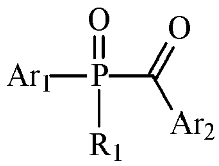

(III)

wherein $R_1$ is selected from alkyl or an optionally substituted aryl; and $Ar_1$ and $Ar_2$ are independently an optionally substituted aryl.

As used herein, the term *"aryl"* means a polyunsaturated aromatic group. The aryl may contain a single ring (i.e. phenyl) or more than one ring wherein at least one ring is aromatic. When the aryl comprises more than one more ring, the rings may be fused, linked via a covalent bond (for example biphenyl). The aromatic ring may optionally comprise one to two additional fused rings (i.e. cycloalkyl, heterocycloalkyl or heteroaryl). The term *"aryl"* also encompasses partially hydrogenated derivatives of the carbocyclic system is described above. Examples include phenyl, naphtyl, biphenyl, phenanthrenyl and naphthacenyl. The term *"optionally substituted aryl"* means an aryl optionally bearing one or more substituents, such as halogen (i.e. Cl, Br, F or I), hydroxy, alkyl, haloalkyl, alkoxy, aryl, aryloxy, alkylaryl, arylalkyl, heteroaryl, thioalkyl, thioaryl, dialkylamino, -C(=O)-R' wherein R' is an optionally substituted group selected from alkyl, aryl and alkylaryl.

The term *"di-acyl phosphine oxide"* means a compound comprising a group of the following formula (IV):

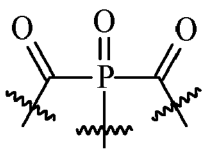

(IV)

there being no other -C(=O)- group directly bound to the phosphorous atom.

In particular, a di-acyl phosphine oxide may correspond to the following formula (V):

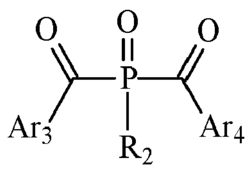

(V)

wherein $R_2$ is selected from alkyl or an optionally substituted aryl; and $Ar_3$ and $Ar_4$ are independently an optionally substituted aryl.

The photoinitiator component may comprise or consist of a phosphinate. As used herein, the term *"phosphinate"* means a compound having a group of the following formula (VI):

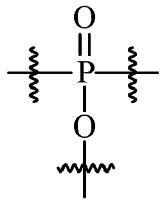
(VI)

there being no other -O- group directly bound to the phosphorous atom.

The use of phosphinates is particularly advantageous as phosphinates have low melting points and may be liquid at room temperature.

In particular, the phosphinate may be an alkyl phosphinate. As used herein, the term *"alkyl phosphinate"* means a compound having a group of the following formula (VII):

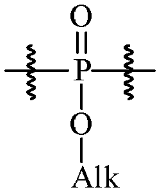
(VII)

wherein Alk is an alkyl, in particular a C1-C6 alkyl, more particularly methyl or ethyl..

The photoinitiator component may comprise or consist of a mono-acyl phosphinate. As used herein, the term *"mono-acyl phosphinate"* means a compound having a group of the following formula (VIII):

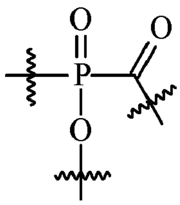
(VIII).

In particular, a mono-acyl phosphinate may correspond to the following formula (IX):

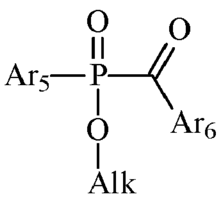
(IX)

wherein Alk is as defined above; and $Ar_5$ and $Ar_6$ are independently an optionally substituted aryl.

The photoinitiator component may comprise or consist of a di-acyl phosphinate. As used herein, the term *"di-acyl phosphinate"* means a compound having a group of the following formula (X):

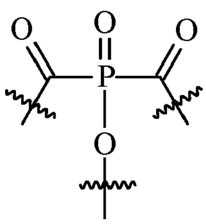
(X).

In particular, a di-acyl phosphinate may correspond to the following formula (XI):

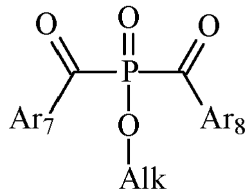

(XI)

wherein Alk is as defined above; and $Ar_7$ and $Ar_8$ are independently an optionally substituted aryl.

In particular, the photoinitiator component may comprise or consist of a compound according to one of formula (III), (V), (IX) or (XI) as defined above, wherein

Alk is methyl or ethyl;
$R_1$, $Ar_1$ and $Ar_5$ are phenyl;
$R_2$ is phenyl or trimethylpentyl;
$Ar_2$, $Ar_3$, $Ar_4$, $Ar_6$, $Ar_7$ and $Ar_8$ are independently represented by the following formula (XII):

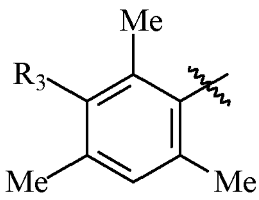

(XII)

$R_3$ is H, or -C(=O)-R' and R' is an optionally substituted group selected from alkyl, aryl and alkylaryl.

More particularly, the photoinitiator component may comprise or consist of a compound selected from

- (2,4,6-trimethylbenzoyl)diphenylphosphine oxide also known as SpeedCure TPO;
- bis(2,4,6-trimethylbenzoyl)phenylphosphine oxide also known as SpeedCure BPO or BAPO;
- ethyl (2,4,6-trimethylbenzoyl)phenyl phosphinate, also known as SpeedCure TPO-L;
- a polymeric TPO-L , such as a polymeric TPO-L sold under reference Omnipol TP by IGM Resins;
- a liquid BAPO such as bis(2,4,6-trimethylbenzoyl)-n-butoxyphosphine oxide;
- bis(2,6-dimethoxybenzoyl)(2,4,4-trimethylpentyl)phosphine oxide;
- ethyl (3-benzoyl-2,4,6-trimethylbenzoyl)phenyl phosphinate, also known as SpeedCure XKm;

and combinations thereof.

According to a preferred embodiment, the photoinitiator component may comprise or consist of a compound chosen from (2,4,6-trimethylbenzoyl)diphenylphosphine oxide (TPO), bis(2,4,6-trimethyl benzoyl)phenylphosphine oxide (BAPO), ethyl (2,4,6-trimethylbenzoyl)phenyl phosphinate (TPO-L), ethyl (3-benzoyl-2,4,6-trimethylbenzoyl)phenyl phosphinate (XKM) and combinations thereof.

According to a particularly preferred embodiment, the photoinitiator component may comprise or consist of diphenyl(2,4,6-trimethylbenzoyl)phosphine oxide (TPO).

The photoinitiator component may be present in the photosensitive composition at an amount from 0.01 to 60%, in particular from 0.1 to 50%, more particularly from 1 to 5%, by weight relative to the total weight of the photosensitive composition. Such amount may be from 0.01 to 0.5%; or from 0.5 to 1%; or from 1 to 5%; or from 5 to 10%; or from 10 to 15%; or from 15 to 20%; or from 20 to 25%; or from 25 to 30%; or from 30 to 35%; or from 35 to 40%; or from 40 to 45%; or from 45 to 50%; or from 50 to 55%; or from 55 to 60%, by weight relative to the total weight of the photosensitive composition.

If a mixture of photoinitiators is used, the weight percentage of the photoinitiator component may correspond to % by weight of the mixture of photoinitiators based on the weight of the photosensitive composition.

<u>Photoinhibitor component</u>

The photosensitive composition of the invention comprises a photoinhibitor component. The photoinhibitor component comprises or consists of a photoinhibitor. The photoinhibitor component may comprise or consist of a mixture of photoinhibitors.

By *"photoinhibitor"* is meant a compound that, upon irradiation with light, forms an inhibiting species (i.e. a radical) that inhibits and/or retards the polymerization of a polymerizable monomer. In particular, when activated by light, a photoinhibitor does not initiate the polymerization of a polymerizable monomer. In particular, when not activated by light, (e.g., in the inactive state), a photoinhibitor does not inhibit and/or does not retard the polymerization of a polymerizable monomer. In particular, when not activated by light, a photoinhibitor does not have initiating activity. Consequently, the formation and persistence of the polymerization inhibiting species (e.g., a radical that inhibits polymerization) may only occur when the appropriate activating wavelength irradiates the photoinhibitor. Once the polymerization inhibiting species is no longer activated by light, it may return to an inactive state.

The photoinhibitor component of the invention may comprise or consist of a hexaarylbiimidazole (HABI). By *"hexaarylbiimidazole"* is meant a compound comprising two imidazole rings and six aryl groups, in particular two imidazole rings linked to one another by a direct bond (i.e. C-N or C-C bond), each imidazole ring bearing three optionally substituted aryl (i.e. phenyl) groups. The hexaarylbiimidazole may be chosen from a bridged or a non-bridged HABI. By *"bridged HABI"* is meant a HABI in which an aryl group of one imidazole ring is linked to an aryl group of the other imidazole ring (e.g., by one or more covalent bonds or by linker) such that they do not diffuse away from one another upon hemolytic cleavage of the bond connecting the imidazole rings (e.g., by light). In particular, the hexaarylbiimidazole may be a non-bridged hexaarylbiimidazole, in particular a non-bridged hexaarylbiimidazole of the following formula:

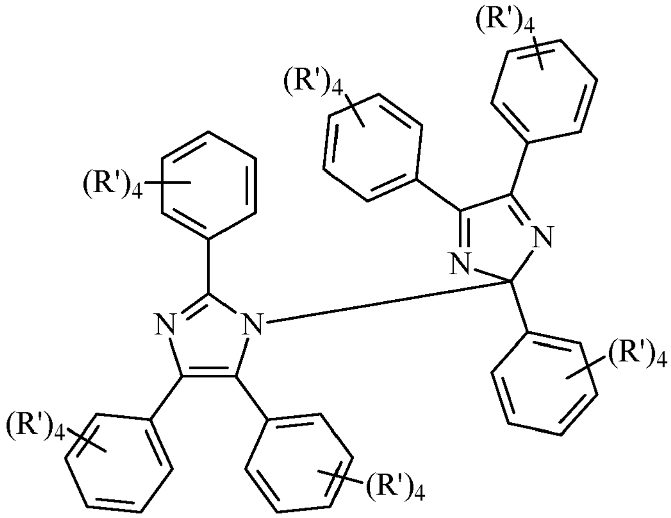

wherein each R' is independently selected from H, halogen, OH, CN, $NO_2$, alkyl, aryl, alkoxy, dialkylamino or diarylamino.

Hexaarylbiimidazoles (HABI) were developed in the 1960s as photochromic molecules by Hayashi and Maeda (see, e.g., Hayashi and Maeda (1960) "Preparation of a new phototropic substance" Bull. Chem. Soc. Jpn. 33(4): 565-66, incorporated herein by reference). Upon irradiation, the light-induced homolytic cleavage of the HABI C-N bond produces two radicals (e.g., triphenylimidazolyl radicals *("TPIR"),* also known as lophyl radicals). Recombination of the two radicals in a *"back reaction"* allows to reform the HABI imidazole dimer (accordingly, also called a triphenylimidazolyl dimer *"TPID").* The recombination *"back reaction"* is driven by thermal energy and radical diffusion. The lophyl radical has a large absorption band in the visible region of the electromagnetic spectrum, whereas HABI absorb strongly in the UV region and weakly in the blue region of the electromagnetic spectrum and is therefore either colorless or yellow. Consequently, HABI generate a colored radical species upon UV light irradiation and the radicals slowly reform to produce the colorless HABI imidazole dimer when light irradiation is stopped.

Cleavage of the HABI C-N bond by UV irradiation occurs in less than 100 fs and is thus nearly (e.g., substantially, effectively) instantaneous; recombination of the radicals to reform HABI is a second order reaction that occurs over a time of up to a few minutes at room temperature. Thus, the lophyl radicals formed from HABI have a half-life of tens of seconds to several (e.g., 5 to 10 or more) minutes (see, e.g., Satoh et al. (2007) "Ultrafast laser photolysis study on photodissociation dynamics of a hexaarylbiimidazole derivative" Chem. Phys. Lett. 448 (4-6): 228-31; Sathe, et al. (2015) "Re-examining the Photomediated Dissociation and Recombination Kinetics of Hexaarylbiimidazoles" Ind. Eng. Chem. Res. 54 (16): 4203-12, each of which is incorporated herein by reference).

Similar to the conventional HABI molecules, the bridged HABI molecules form radicals instantaneously upon exposure to UV light. However, the radicals are linked by a covalent bond (e.g., one or more covalent bonds and/or, e.g., a linker), which prevents diffusion of the radicals away from one another and thus accelerates the thermally driven reformation of the bridged HABI molecule. Accordingly, the bridged HABI molecules instantaneously produce radicals upon UV light irradiation and the radicals rapidly disappear when UV irradiation is stopped.

According to a preferred embodiment, the photoinhibitor component may comprise or consist of a 2-o-chloro substituted hexaphenylbiimidazole in which the other positions on the phenyl radicals are unsubstituted or substituted with chloro, methyl or methoxy.

According to a particularly preferred embodiment, the photoinhibitor component may comprise or consist of 2-(2-chlorophenyl)-1-[2-(2-chlorophenyl)-4,5-diphenyl-2H-imidazol-2-yl]-4,5-diphenyl-1H-imidazole (also known as SpeedCure BCIM).

The photoinhibitor component may be present in the photosensitive composition at an amount from 0.01 to 30%, in particular from 0.1 to 20%, more particularly from 1 to 10%, by weight relative to the total weight of the photosensitive composition. Such amount may be from 0.01 to 0.5%; or from 0.5 to 1%; or from 1 to 2%; or from 2 to 4%; or from 4 to 6%; or from 6 to 8%; or from 8 to 10%; or from 10 to 12%; or from 12 to 14%; or from 14 to 16%; or from 16 to 18%; or from 18 to 20%; or from 20 to 22%; or from 22 to 24%; or from 24 to 26%; or from 26 to 28%; or from 28 to 30%, by weight relative to the total weight of the photosensitive composition.

If a mixture of photoinhibitors is used, the weight percentage of the photoinhibitor component corresponds to % by weight of the mixture of photoinhibitors based on the weight of the photosensitive composition.

Photosensitizer component

The photosensitive composition of the invention comprises a photosensitizer component. The photosensitizer component comprises or consists of a photosensitizer. The photosensitizer component may comprise or consist of a mixture of photosensitizers.

By *"photosensitizer"* is meant a compound that, upon irradiation with light, transfers energy to another compound of the photosensitive composition and returns to its initial state. A photosensitizer may be chemically unchanged after the polymerization as it has not reacted with other chemical species. The photosensitizer (in the presence of the photoinhibitor) may improve the photoinhibiting activity of the photoinhibitor. The photosensitizer (in the presence of the photoinitiator) may improve the photoinitiating activity of the photoinitiator.

The photosensitizer component may comprise or consist of an aryl ketone. By *"aryl ketone"* is meant a compound having at least one -C(=O)-Ar moiety, wherein Ar is an optionally substituted aryl.

According to some embodiments, the photosensitizer is visible. By *"visible"* is meant that the photosensitizer can shift the photoabsorbance of the photoinitiator and/or the photoinhibitor to a wavelength in the visible range such as an absorption wavelength from 350 to 550 nm.

More particularly, the photosensitizer component may comprise or consist of an aryl ketone chosen from arylidene aryl ketones, benzophenones, thioxanthones, anthraquinones, ketocoumarins, and benzylideneacetone.

In case the photosensitizer component comprises an arylidene aryl ketone, such compound can be as described in patent US 4859551. Examples of such compounds may include 2-(4'-diethylamino-2'-methylbenzylidene)-1-indanone, 2-(4'-diethylaminobenzyliden-1-indanone, 8-(4'-dimethylaminobenzylidene)-acenaphthalene-7-one, 2-(4'-diethylamino-2'-methylbenzylidene)-1-tetralone, 4-diethylamino-2-methylbenzylideneacetophenone, 4'-dimethylaminobenzylidene-4-dimethylaminoacetophenone, 4'-diethylamino-2'-methylbenzylidene-2-(B-(B'-methoxyethoxy)-ethoxy)acetophenone, 4'-diethylamino-2'-methylbenzylidene-2-methylacetophenone, 4'-diethylamino-2'-methylbenzylidene-4-fluoroacetophenone, 4'-diethylamino-2'-methylbenzylidene-4-cyanoacetophenone, 2-(4'-diethylaminobenzylidene)-3-phenyl-1-chromanone, 2-(4'-diethylaminobenzylidene)-1-chromanone, 2-(4'-diethylaminobenzylidene)-chroman-1,3-dione, 2-(4'-di(B-chloroethyl)aminobenzylidene)-3-hydroxy-1-indanone, 2-(4'-diethylamino-2'-methylbenzylidene)-3-hydroxy-1-indanone, 2-(4'-dimethylaminocinnamylidene)-3-hydroxy-1-indanone, 2-(4'-diethylamino-2'-methylbenzylidene)-1-tetralone, 2-(4'-diethylamino-2'-methylbenzylidene)-1-benzosuberone, 2-(4'-diethylamino-2'-methylbenzylidene)-5,6-dimethoxy-1-indanone, 4'-diethylamino-2'-methylbenzylidene-3,4-methylenedioxyacetophenone, 4'-diethylamino-2'-methylbenzylidene-4-methoxyacetophenone, 4'-diethylamino-2'-methylbenzylidene-3-methoxyacetophenone, 4'-diethylamino-2'-methylbenzylidene-4-methylacetophenone, 2-(4'-diethylamino-2'-methoxybenzylidene)-1-indanone, 2-(9'-julolyidene)-1-indanone, 2-(4'-diethylaminobenzylidene)-1-tetralone, 2-(4'-diethylaminobenzylidene)-propiophenone, 2-(4'-diethylamino-2'-methylbenzylidene)-propiophenone, 4-diethylaminobenzylidene-deoxybenzoin, 2-(4'-diethylaminobenzylidene)-1-indanone, 2-(4'-diethylaminobenzylidene)-3-gemdimethyl-1-indanone, 4'-diethylamino-2'-methylbenzylidene-4-hydroxyacetophenone, 4'-dimethylaminobenzylidene-3-hydroxyacetophenone, 2-(N-ethyl-1,2,3,4-tetrahydro-6-quinolylidene-1-chromanone.

In case the photosensitizer component comprises a benzophenone, such compound may be chosen from benzophenone, 4,4'-bis(diethylamino)-benzophenone, 4,4'-bis(dimethylamino)benzophenone, 4,4'-dihydroxybenzophenone, 4-(dimethylamino)benzophenone, 2,5-dimethylbenzophenone, 3,4-dimethylbenzophenone, 3-hydroxybenzophenone, 4-hydroxybenzophenone, 2-methylbenzophenone, 3-methylbenzophenone, and mixtures thereof.

In case the photosensitizer component comprises a thioxanthone, such compound may be chosen from thioxanthone, 2-isopropylthioxanthone, diethyl thioxanthone, 1-chloro-4-propoxythioxanthone, and mixtures thereof.

In case the photosensitizer component comprises an anthraquinone, such compound may be chosen from

anthraquinone, 2-methylanthraquinone, 2-ethylanthraquinone, 2-chloroanthraquinone, 2-benzylanthraquinone, 2-t-butylanthraquinone, 1,2-benzo-9,10-anthraquinone, anthraquinone-2-sulfonic acid, and mixtures thereof.

According to preferred embodiments, the photosensitizer component comprises 4,4'-bis(diethylamino)-benzophenone.

The photosensitizer component may be present in the photosensitive composition at an amount from 0.01 to 10%, in particular from 0.1 to 10%, more particularly from 1 to 5%, by weight relative to the total weight of the photosensitive composition. Such amount may be from 0.01 to 0.5%; or from 0.5 to 1%; or from 1 to 2%; or from 2 to 4%; or from 4 to 6%; or from 6 to 8%; or from 8 to 10% by weight relative to the total weight of the photosensitive composition.

If a mixture of photosensitizers is used, the weight percentage of the photosensitizer component corresponds to % by weight of the mixture of photosensitizers based on the weight of the photosensitive composition.

Chain transfer agent component

The photosensitive composition of the invention comprises a chain transfer agent component. The chain transfer agent component comprises or consists of a chain transfer agent. The chain transfer agent component may comprise or consist of a mixture of chain transfer agents.

By *"chain transfer agent'* is meant a compound capable of reacting with a radical to generate another active radical. Conventionally, chain transfer agents are used during a polymerization reaction to control the molecular weights of the polymers. A chain transfer agent may comprise a moiety that reacts with a growing polymer radical, causing the growing chain to terminate while creating a new reactive species capable of initiating polymerization. A chain transfer agent may not produce a reactive species (initiating species or inhibiting species) upon irradiation with light.

In particular, the chain transfer agent component may comprise a chain transfer agent chosen from $\alpha$-amino acids, compounds comprising at least one sulfur atom and mixtures thereof.

The compound comprising at least one sulfur atom may be chosen from a thiol, a thioether, a disulfide, a thiocarbamate, a thiocarbonylthio and combinations thereof, in particular a thiol, a thiocarbonylthio and combinations thereof, more particularly a thiocarbonylthio.

As used herein, a thiol is a compound comprising a -SH group.

As used herein, a thioether is a compound comprising a -S- bond. A thioether may be linear or cyclic

As used herein, a disulfide is a compound comprising a -S-S- bond.

As used herein, a thiocarbamate is a compound comprising a -O-C(=S)-NH-bond or a -S-C(=O)-NH- bond.

As used herein, a thiocarbonylthio is a compound comprising a -S-C(=S)-bond wherein the thiocarbonyl group is covalently linked to an atom X selected from C, S, O or N. Examples of such groups include dithioesters (X = C), trithiocarbonates (X = S), dithiocarbamates (X = N) and xanthates (X = O). A thiocarbonylthio may be linear or cyclic.

According to preferred embodiments, the chain transfer agent component comprises or consists of a chain transfer agent chosen from N-phenylglycine, 2-mercaptobenzothiazole, 2-mercaptobenzoxazole, 2-mercaptobenzimidazole, pentaerythritol tetrakis (mercaptoacetate), 4-acetamidothiophenol, mercaptosuccinic acid, dodecanethiol, beta-mercaptoethanol, 2-mercaptoethane sulfonic acid, 1-phenyl-4H-tetrazole-5-thiol, 6-mercaptopurine monohydrate, bis-(5-mercapto-1,3,4-thiodiazol-2-yl, 2-mercapto-5-nitrobenzimidazole, 2-mercapto-4-sulfo-6-chlorobenzoxazole, 1-hexanethiol, methyl 3-mercaptopropionate, benzyl mercaptane, triphenylmethane thiol, thiophenol, 1-napthalene thiol, thioacetic acid, thiobenzoic acid, 2-mercaptobenzoic acid, 4,4'-thiobisbenzenethiol, 2-mercapto pyrimidine, trithiocyanuric acid, 2-mercaptobenzoic acid, 4-mercaptobenzoic acid, 4-mercaptophenyl acetic acid, 2-methoxy thiophenol, 3-methoxy thiophenol, 4-methoxy thiophenol, 2-(trifluoromethyl) thiophenol, 3-(trifluoromethyl) thiophenol, 4-(trifluoromethyl) thiophenol, 2-aminothiophenol, 3-aminothiophenol, thioanisole, 2-(methylthio)benzoic acid and mixtures thereof.

Preferably, the chain transfer agent component comprises or consists of 2-mercaptobenzothiazole.

The chain transfer agent may be present in the photosensitive composition at an amount from 0.1 to 90%, in particular from 10 to 85% by weight, more particularly from 40 to 85%, by weight relative to the total weight of the photosensitive composition. Such amount may be from 0.1 to 5%; or from 5 to 10%; or from 10 to 15%; or from 15 to 20%; or from 20 to 25%; or from 25 to 30%; or from 30 to 35%; or from 35 to 40%; or from 40 to 45%; or from 45 to 50%; or from 50 to 55%; or from 55 to 60%; or from 60 to 65%; or from 65 to 70%; or from 70 to 75%; or from 75 to 80%; or from 80 to 85%; or from 85 to 90% by weight relative to the total weight of the photosensitive composition.

If a mixture of chain transfer agents is used, the weight percentage of the chain transfer agent component corresponds to % by weight of the mixture of chain transfer agents based on the weight of the photosensitive composition.

Preferred embodiments

In a preferred embodiment, the photosensitive composition comprises or consists of:

- a photoinitiator component comprising a phosphine oxide;

- a photoinhibitor component comprising a hexaarylbiimidazole;
- a photosensitizer component comprising an aryl ketone; and
- a chain transfer agent component comprising a thiocarbonylthio.

In particular, the photosensitive composition may consist of:

- one or more phosphine oxides;
- one or more hexaarylbiimidazoles;
- one or more aryl ketones; and
- one or more thiocarbonylthio.

In a particularly preferred embodiment, the photosensitive composition comprises or consists of:

- 0.5 to 10%, in particular 1 to 5%, of photoinitiator component;
- 1 to 20%, in particular 5 to 15%, of photoinhibitor component;
- 0.5 to 10%, in particular 1 to 5%, of photosensitizer component; and
- 65 to 95%, in particular 75 to 85%, of chain transfer agent component;

wherein the % are % by weight based on the weight of the photosensitive composition. The total amount of photoinitiator component, photoinhibitor component, photosensitizer component and chain transfer agent component may represent 100% of the weight of the photosensitive composition.

In an even more preferred embodiment, the photosensitive composition comprises or consists of:

- 0.5 to 10%, in particular 1 to 5%, of total phosphine oxide;
- 1 to 20%, in particular 5 to 15%, of total hexaarylbiimidazole;
- 0.5 to 10%, in particular 1 to 5%, of total aryl ketone; and
- 65 to 95%, in particular 75 to 85%, of total thiocarbonylthio;

wherein the % are % by weight based on the weight of the photosensitive composition. The total amount of phosphine oxide, hexaarylbiimidazole, aryl ketone and thiocarbonylthio may represent 100% of the weight of the photosensitive composition.

In an alternative embodiment, the photosensitive composition comprises or consists of:

- 30 to 60%, in particular 35 to 55%, of photoinitiator component;
- 1 to 10%, in particular 2 to 8%, of photoinhibitor component;
- 0.5 to 10%, in particular 1 to 5%, of photosensitizer component; and
- 30 to 60%, in particular 35 to 55%, of chain transfer agent component;

wherein the % are % by weight based on the weight of the photosensitive composition. The total amount of photoinitiator component, photoinhibitor component, photosensitizer component and chain transfer agent component may represent 100% of the weight of the photosensitive composition.

In particular, the photosensitive composition of the alternative embodiment may comprise or consist of:

- 30 to 60%, in particular 35 to 55%, of total phosphine oxide;
- 1 to 10%, in particular 2 to 8%, of total hexaarylbiimidazole;
- 0.5 to 10%, in particular 1 to 5%, of total aryl ketone; and
- 30 to 60%, in particular 35 to 55%, of total thiocarbonylthio;

wherein the % are % by weight based on the weight of the photosensitive composition. The total amount of phosphine oxide, hexaarylbiimidazole, aryl ketone and thiocarbonylthio may represent 100% of the weight of the photosensitive composition.

Curable composition

The curable composition according to the invention comprises the above photosensitive composition and at least one ethylenically unsaturated compound. Thus, one or more ethylenically unsaturated compound may be present in the curable composition according to the invention. By *"ethylenically unsaturated compound"* is meant a compound comprising a polymerizable carbon-carbon double bond. A polymerizable carbon-carbon double bond is a carbon-carbon

double bond that can react with another carbon-carbon double bond in a polymerization reaction. A polymerizable carbon-carbon double bond is generally comprised in a group selected from acrylate (including cyanoacrylate), methacrylate, acrylamide, methacrylamide, styrene, maleate, fumarate, itaconate, allyl, propenyl, vinyl and combinations thereof, preferably selected from acrylate, methacrylate, vinyl and allyl, more preferably selected from acrylate and methacrylate. The carbon-carbon double bonds of a phenyl ring are not considered as polymerizable carbon-carbon double bonds.

In one embodiment, the ethylenically unsaturated compound may comprises one or more (meth)acrylate-functionalized monomers, one or more (meth)acrylate-functionalized oligomers and mixtures thereof.

As used herein, the term *"(meth)acrylate-functionalized monomer"* means a monomer comprising a (meth)acrylate group, in particular an acrylate group. The term "(meth)acrylate-functionalized oligomer" means an oligomer comprising a (meth)acrylate group, in particular an acrylate group. The term *"(meth)acrylate group"* encompasses acrylate groups ($-O-CO-CH=CH_2$) and methacrylate groups ($-O-CO-C(CHs)=CH_2$).

In one embodiment, the ethylenically unsaturated compound comprises a (meth)acrylate-functionalized monomer. The ethylenically unsaturated compound may comprise a mixture of (meth)acrylate-functionalized monomers.

The (meth)acrylate-functionalized monomer may have a molecular weight of less than 600 g/mol, in particular from 100 to 550 g/mol, more particularly 200 to 500 g/mol.

The (meth)acrylate-functionalized monomer may have 1 to 6 (meth)acrylate groups, in particular 1 to 5 (meth)acrylate groups, more particularly 1 to 3 (meth)acrylate groups.

The (meth)acrylate-functionalized monomer may comprise a mixture of (meth)acrylate-functionalized monomers having different functionalities. For example the (meth)acrylate-functionalized monomer may comprise a mixture of a (meth)acrylate-functionalized monomer containing a single acrylate or methacrylate group per molecule (referred to herein as "mono(meth)acrylate-functionalized compounds") and a (meth)acrylate-functionalized monomer containing 2 or more, preferably 2 or 3, acrylate and/or methacrylate groups per molecule. In another example, the (meth)acrylate-functionalized monomer may comprise a mixture of at least one mono(meth)acrylate-functionalized compound and at least one (meth)acrylate-functionalized monomer containing 3 or more, preferably 4 or more, (meth)acrylate groups per molecule.

The (meth)acrylate functionalized monomer may comprise a mono(meth)acrylate-functionalized monomer. The mono(meth)acrylate-functionalized monomer may advantageously function as a reactive diluent and reduce the viscosity of the composition of the invention.

Examples of suitable mono(meth)acrylate-functionalized monomers include, but are not limited to, mono-(meth)acrylate esters of aliphatic alcohols (wherein the aliphatic alcohol may be straight chain, branched or alicyclic and may be a mono-alcohol, a di-alcohol or a polyalcohol, provided only one hydroxyl group is esterified with (meth)acrylic acid); mono-(meth)acrylate esters of aromatic alcohols (such as phenols, including alkylated phenols); mono-(meth)acrylate esters of alkylaryl alcohols (such as benzyl alcohol); mono-(meth)acrylate esters of oligomeric and polymeric glycols such as diethylene glycol, triethylene glycol, dipropylene glycol, tripropylene glycol, polyethylene glycol, and polypropylene glycol); mono-(meth)acrylate esters of monoalkyl ethers of glycols and oligoglycols; mono-(meth)acrylate esters of alkoxylated (e.g., ethoxylated and/or propoxylated) aliphatic alcohols (wherein the aliphatic alcohol may be straight chain, branched or alicyclic and may be a mono-alcohol, a di-alcohol or a polyalcohol, provided only one hydroxyl group of the alkoxylated aliphatic alcohol is esterified with (meth)acrylic acid); mono-(meth)acrylate esters of alkoxylated (e.g., ethoxylated and/or propoxylated) aromatic alcohols (such as alkoxylated phenols); caprolactone mono(meth)acrylates; and the like.

The following compounds are specific examples of mono(meth)acrylate-functionalized monomers suitable for use in the curable compositions of the present invention: methyl (meth)acrylate; ethyl (meth)acrylate; n-propyl (meth)acrylate; n-butyl (meth)acrylate; isobutyl (meth)acrylate; n-hexyl (meth)acrylate; 2-ethylhexyl (meth)acrylate; n-octyl (meth)acrylate; isooctyl (meth)acrylate; n-decyl (meth)acrylate; n-dodecyl (meth)acrylate; tridecyl (meth)acrylate; tetradecyl (meth)acrylate; hexadecyl (meth)acrylate; 2-hydroxyethyl (meth)acrylate; 2- and 3-hydroxypropyl (meth)acrylate; 2-methoxyethyl (meth)acrylate; 2-ethoxyethyl (meth)acrylate; 2- and 3-ethoxypropyl (meth)acrylate; tetrahydrofurfuryl (meth)acrylate; alkoxylated tetrahydrofurfuryl (meth)acrylate; 2-(2-ethoxyethoxy)ethyl (meth)acrylate; cyclohexyl (meth)acrylate; glycidyl (meth)acrylate; isodecyl (meth)acrylate; lauryl (meth)acrylate; 2-phenoxyethyl (meth)acrylate; alkoxylated phenol (meth)acrylates; alkoxylated nonylphenol (meth)acrylates; cyclic trimethylolpropane formal (meth)acrylate; isobornyl (meth)acrylate; tricyclodecanemethanol (meth)acrylate; tert-butylcyclohexanol (meth)acrylate; trimethylcyclohexanol (meth)acrylate; diethylene glycol monomethyl ether (meth)acrylate; diethylene glycol monoethyl ether (meth)acrylate; diethylene glycol monobutyl ether (meth)acrylate; triethylene glycol monoethyl ether (meth)acrylate; ethoxylated lauryl (meth)acrylate; methoxy polyethylene glycol (meth)acrylates; hydroxyl ethyl-butyl urethane (meth)acrylates; 3-(2-hydroxyalkyl)oxazolidinone (meth)acrylates; and combinations thereof.

The (meth)acrylate functionalized monomer may comprise a (meth)acrylate-functionalized monomer containing two or more (meth)acrylate groups per molecule.

Examples of suitable (meth)acrylate-functionalized monomers containing two or more (meth)acrylate groups per molecule include acrylate and methacrylate esters of polyhydric alcohols (organic compounds containing two or

more, e.g., 2 to 6, hydroxyl groups per molecule). Specific examples of suitable polyhydric alcohols include C2-20 alkylene glycols (glycols having a C2-10 alkylene group may be preferred, in which the carbon chain may be branched; e.g., ethylene glycol, trimethylene glycol, 1,2-propylene glycol, 1,2-butanediol, 1,3-butanediol, 2,3-butanediol, tetramethylene glycol (1,4-butanediol), 1,5-pentanediol, 1,6-hexanediol, 1,8-octanediol, 1,9-nonanediol, 1,12-dodecanediol, cyclohexane-1,4-dimethanol, bisphenols, and hydrogenated bisphenols, as well as alkoxylated (e.g., ethoxylated and/or propoxylated) derivatives thereof), diethylene glycol, glycerin, alkoxylated glycerin, triethylene glycol, dipropylene glycol, tripropylene glycol, trimethylolpropane, alkoxylated trimethylolpropane, ditrimethylolpropane, alkoxylated ditrimethylolpropane, pentaerythritol, alkoxylated pentaerythritol, dipentaerythritol, alkoxylated dipentaerythritol, cyclohexanediol, alkoxylated cyclohexanediol, cyclohexanedimethanol, alkoxylated cyclohexanedimethanol, norbornene dimethanol, alkoxylated norbornene dimethanol, norbornane dimethanol, alkoxylated norbornane dimethanol, polyols containing an aromatic ring, cyclohexane-1,4-dimethanol ethylene oxide adducts, bis-phenol ethylene oxide adducts, hydrogenated bisphenol ethylene oxide adducts, bisphenol propylene oxide adducts, hydrogenated bisphenol propylene oxide adducts, cyclohexane-1,4-dimethanol propylene oxide adducts, sugar alcohols and alkoxylated sugar alcohols. Such polyhydric alcohols may be fully or partially esterified (with (meth)acrylic acid, (meth)acrylic anhydride, (meth)acryloyl chloride or the like), provided they contain at least two (meth)acrylate functional groups per molecule. As used herein, the term "alkoxylated" refers to compounds containing one or more oxyalkylene moieties (e.g., oxyethylene and/or oxypropylene moieties). An oxyalkylene moiety corresponds to the general structure -R-O-, wherein R is a divalent aliphatic moiety such as $-CH_2CH_2-$ or $-CH_2CH(CH_3)-$. For example, an alkoxylated compound may contain from 1 to 30 oxyalkylene moieties per molecule.

Exemplary (meth)acrylate-functionalized monomers containing two or more (meth)acrylate groups per molecule may include ethoxylated bisphenol A di(meth)acrylates; triethylene glycol di(meth)acrylate; ethylene glycol di(meth)acrylate; tetraethylene glycol di(meth)acrylate; polyethylene glycol di(meth)acrylates; 1,4-butanediol diacrylate; 1,4-butanediol dimethacrylate; diethylene glycol diacrylate; diethylene glycol dimethacrylate, 1,6-hexanediol diacrylate; 1,6-hexanediol dimethacrylate; neopentyl glycol diacrylate; neopentyl glycol di(meth)acrylate; polyethylene glycol (600) dimethacrylate (where 600 refers to the approximate number average molecular weight of the polyethylene glycol portion); polyethylene glycol (200) diacrylate; 1,12-dodecanediol dimethacrylate; tetraethylene glycol diacrylate; triethylene glycol diacrylate, 1,3-butylene glycol dimethacrylate, tripropylene glycol diacrylate, polybutadiene diacrylate; methyl pentanediol diacrylate; polyethylene glycol (400) diacrylate; ethoxylated$_2$ bisphenol A dimethacrylate; ethoxylated$_3$ bisphenol A dimethacrylate; ethoxylated$_3$ bisphenol A diacrylate; cyclohexane dimethanol dimethacrylate; cyclohexane dimethanol diacrylate; ethoxylated$_{10}$ bisphenol A dimethacrylate (where the numeral following *"ethoxylated"* is the average number of oxyalkylene moieties per molecule); dipropylene glycol diacrylate; ethoxylated$_4$ bisphenol A dimethacrylate; ethoxylated$_6$ bisphenol A dimethacrylate; ethoxylated$_8$ bisphenol A dimethacrylate; alkoxylated hexanediol diacrylates; alkoxylated cyclohexane dimethanol diacrylate; dodecane diacrylate; ethoxylated$_4$ bisphenol A diacrylate; ethoxylated$_{10}$ bisphenol A diacrylate; polyethylene glycol (400) dimethacrylate; polypropylene glycol (400) dimethacrylate; metallic diacrylates; modified metallic diacrylates; metallic dimethacrylates; polyethylene glycol (1000) dimethacrylate; methacrylated polybutadiene; propoxylated$_2$ neopentyl glycol diacrylate; ethoxylated30 bisphenol A dimethacrylate; ethoxylated$_{30}$ bisphenol A diacrylate; alkoxylated neopentyl glycol diacrylates; polyethylene glycol dimethacrylates; 1,3-butylene glycol diacrylate; ethoxylated$_2$ bisphenol A dimethacrylate; dipropylene glycol diacrylate; ethoxylated$_4$ bisphenol A diacrylate; polyethylene glycol (600) diacrylate; polyethylene glycol (1000) dimethacrylate; tricyclodecane dimethanol diacrylate; propoxylated neopentyl glycol diacrylates such as propoxylated$_2$ neopentyl glycol diacrylate; diacrylates of alkoxylated aliphatic alcohols; trimethylolpropane trimethacrylate; trimethylolpropane triacrylate; tris (2-hydroxyethyl) isocyanurate triacrylate; ethoxylated$_{20}$ trimethylolpropane triacrylate; pentaerythritol triacrylate; ethoxylated3 trimethylolpropane triacrylate; propoxylated$_3$ trimethylolpropane triacrylate; ethoxylated$_6$ trimethylolpropane triacrylate; propoxylated$_6$ trimethylolpropane triacrylate; ethoxylated9 trimethylolpropane triacrylate; alkoxylated trifunctional acrylate esters; trifunctional methacrylate esters; trifunctional acrylate esters; propoxylated$_3$ glyceryl triacrylate; propoxylated$_{5.5}$ glyceryl triacrylate; ethoxylated$_{15}$ trimethylolpropane triacrylate; trifunctional phosphoric acid esters; trifunctional acrylic acid esters; pentaerythritol tetraacrylate; di-trimethylolpropane tetraacrylate; ethoxylated$_4$ pentaerythritol tetraacrylate; pentaerythritol polyoxyethylene tetraacrylate; dipentaerythritol pentaacrylate; and pentaacrylate esters.

In one embodiment, the ethylenically unsaturated compound comprises a (meth)acrylate-functionalized oligomer. The ethylenically unsaturated compound may comprise a mixture of (meth)acrylate-functionalized oligomers.

The (meth)acrylate-functionalized oligomer may be selected in order to enhance the flexibility, strength and/or modulus, among other attributes, of a cured polymer prepared using the curable composition of the present invention.

The (meth)acrylate functionalized oligomer may have 1 to 18 (meth)acrylate groups, in particular 2 to 6 (meth)acrylate groups, more particularly 2 to 6 acrylate groups.

The (meth)acrylate functionalized oligomer may have a number average molecular weight equal or more than 600 g/mol, in particular 800 to 15,000 g/mol, more particularly 1,000 to 5,000 g/mol.

In particular, the (meth)acrylate-functionalized oligomers may be selected from the group consisting of

(meth)acrylate-functionalized urethane oligomers (sometimes also referred to as *"urethane (meth)acrylate oligomers," "polyurethane (meth)acrylate oligomers"* or *"carbamate (meth)acrylate oligomers"),* (meth)acrylate-functionalized epoxy oligomers (sometimes also referred to as *"epoxy (meth)acrylate oligomers"),* (meth)acrylate-functionalized polyether oligomers (sometimes also referred to as *"polyether (meth)acrylate oligomers"),* (meth)acrylate-functionalized polydiene oligomers (sometimes also referred to as *"polydiene (meth)acrylate oligomers"),* (meth)acrylate-functionalized polycarbonate oligomers (sometimes also referred to as *"polycarbonate (meth)acrylate oligomers"*), and (meth)acrylate-functionalized polyester oligomers (sometimes also referred to as "polyester (meth)acrylate oligomers") and mixtures thereof.

Preferably, the (meth)acrylate-functionalized oligomer comprises a (meth)acrylate-functionalized urethane oligomer, more preferably an acrylate-functionalized urethane oligomer.

Advantageously, the (meth)acrylate-functionalized oligomer comprises a (meth)acrylate-functionalized urethane oligomer having two (meth)acrylate groups, more preferably an acrylate-functionalized urethane oligomer having two acrylate groups.

Exemplary polyester (meth)acrylate oligomers include the reaction products of acrylic or methacrylic acid or mixtures or synthetic equivalents thereof with hydroxyl group-terminated polyester polyols. The reaction process may be conducted such that all or essentially all of the hydroxyl groups of the polyester polyol have been (meth)acrylated, particularly in cases where the polyester polyol is difunctional. The polyester polyols can be made by polycondensation reactions of polyhydroxyl functional components (in particular, diols) and polycarboxylic acid functional compounds (in particular, dicarboxylic acids and anhydrides). The polyhydroxyl functional and polycarboxylic acid functional components can each have linear, branched, cycloaliphatic or aromatic structures and can be used individually or as mixtures.

Examples of suitable epoxy (meth)acrylates include the reaction products of acrylic or methacrylic acid or mixtures thereof with an epoxy resin (polyglycidyl ether or ester). The epoxy resin may, in particular, by selected from bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, epoxy novolak resin, hydrogenated bisphenol A diglycidyl ether, hydrogenated bisphenol F diglycidyl ether, hydrogenated bisphenol S diglycidyl ether, 3,4-epoxycyclohexylmethyl-3',4'-epoxycyclohexanecarboxylate, 2-(3,4-epoxycyclohexyl-5,5-spiro-3,4-epoxy)cyclohexane-1,4-dioxane, bis(3,4-epoxycyclohexylmethyl)adipate, vinylcyclohexene oxide, 4-vinylepoxycyclohexane, bis(3,4-epoxy-6-methylcyclohexylmethyl)adipate,3,4-epoxy-6-methylcyclohexy l-3',4'-epoxy-6'-methylcyclohexanecarboxylate, methylenebis(3,4-epoxycyclohexane), dicyclopentadiene diepoxide, di(3,4-epoxycyclohexylmethyl) ether of ethylene glycol, ethylenebis(3, 4-epoxycyclohexanecarboxylate), 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether, polyglycidyl ethers of a polyether polyol obtained by the addition of one or more alkylene oxides to an aliphatic polyhydric alcohol such as ethylene glycol, propylene glycol, and glycerol, diglycidyl esters of aliphatic long-chain dibasic acids, monoglycidyl ethers of aliphatic higher alcohols, monoglycidyl ethers of phenol, cresol, butyl phenol, or polyether alcohols obtained by the addition of alkylene oxide to these compounds, glycidyl esters of higher fatty acids, epoxidized soybean oil, epoxybutylstearic acid, epoxyoctylstearic acid, epoxidized linseed oil, epoxidized polybutadiene, and the like.

Suitable polyether (meth)acrylate oligomers include, but are not limited to, the condensation reaction products of acrylic or methacrylic acid or synthetic equivalents or mixtures thereof with polyetherols which are polyether polyols (such as polyethylene glycol, polypropylene glycol or polytetramethylene glycol). Suitable polyetherols can be linear or branched substances containing ether bonds and terminal hydroxyl groups. Polyetherols can be prepared by ring opening polymerization of cyclic ethers such as tetrahydrofuran or alkylene oxides (e.g., ethylene oxide and/or propylene oxide) with a starter molecule. Suitable starter molecules include water, polyhydroxyl functional materials, polyester polyols and amines.

Polyurethane (meth)acrylate oligomers (sometimes also referred to as *"urethane (meth)acrylate oligomers"*) suitable for use in the curable compositions of the present invention include urethanes based on aliphatic, cycloaliphatic and/or aromatic polyester polyols and polyether polyols and aliphatic, cycloaliphatic and/or aromatic polyester diisocyanates and polyether diisocyanates capped with (meth)acrylate end-groups. Suitable polyurethane (meth)acrylate oligomers include, for example, aliphatic polyester-based urethane di- and tetra-acrylate oligomers, aliphatic polyether-based urethane di- and tetra-acrylate oligomers, as well as aliphatic polyester/polyether-based urethane di- and tetra-acrylate oligomers.

The polyurethane (meth)acrylate oligomers may be prepared by reacting aliphatic, cycloaliphatic and/or aromatic polyisocyanates (e.g., diisocyanate, triisocyanate) with OH group terminated polyester polyols, polyether polyols, polycarbonate polyols, polycaprolactone polyols, polyorganosiloxane polyols (e.g., polydimethylsiloxane polyols), or polydiene polyols (e.g., polybutadiene polyols), or combinations thereof to form isocyanate-functionalized oligomers which are then reacted with hydroxyl-functionalized (meth)acrylates such as hydroxyethyl acrylate or hydroxyethyl methacrylate to provide terminal (meth)acrylate groups. For example, the polyurethane (meth)acrylate oligomers may contain two, three, four or more (meth)acrylate functional groups per molecule. Other orders of addition may also be practiced to prepare the polyurethane (meth)acrylate, as is known in the art. For example, the hydroxyl-functionalized (meth)acrylate

may be first reacted with a polyisocyanate to obtain an isocyanate-functionalized (meth)acrylate, which may then be reacted with an OH group terminated polyester polyol, polyether polyol, polycarbonate polyol, polycaprolactone polyol, polydimethysiloxane polyol, polybutadiene polyol, or a combination thereof. In yet another embodiment, a polyisocyanate may be first reacted with a polyol, including any of the aforementioned types of polyols, to obtain an isocyanate-functionalized polyol, which is thereafter reacted with a hydroxyl-functionalized (meth)acrylate to yield a polyurethane (meth)acrylate. Alternatively, all the components may be combined and reacted at the same time.

Suitable acrylic (meth)acrylate oligomers (sometimes also referred to in the art as *"acrylic oligomers"*) include oligomers which may be described as substances having an oligomeric acrylic backbone which is functionalized with one or (meth)acrylate groups (which may be at a terminus of the oligomer or pendant to the acrylic backbone). The acrylic backbone may be a homopolymer, random copolymer or block copolymer comprised of repeating units of acrylic monomers. The acrylic monomers may be any monomeric (meth)acrylate such as C1-C6 alkyl (meth)acrylates as well as functionalized (meth)acrylates such as (meth)acrylates bearing hydroxyl, carboxylic acid and/or epoxy groups. Acrylic (meth)acrylate oligomers may be prepared using any procedures known in the art, such as by oligomerizing monomers, at least a portion of which are functionalized with hydroxyl, carboxylic acid and/or epoxy groups (e.g., hydroxyalkyl(meth)acrylates, (meth)acrylic acid, glycidyl (meth)acrylate) to obtain a functionalized oligomer intermediate, which is then reacted with one or more (meth)acrylate-containing reactants to introduce the desired (meth)acrylate functional groups.

In case the ethylenically unsaturated compound is a vinyl compound (monomer or oligomer), such compound may be chosen from:

- N-vinyl compounds, such as N-vinylpyrrolidone (NVP), N-vinylcaprolactam (NVC), N-vinylimidazole, N-vinyl-N-methylacetamide (VIMA);
- O-vinyl compounds, such as ethyl vinyl ether, n-butyl vinyl ether, isobutyl vinyl ether, tert-butyl vinyl ether, cyclohexyl vinyl ether (CHVE), 2-ethylhexyl vinyl ether (EHVE), dodecyl vinyl ether (DDVE), octadecyl vinyl ether (ODVE), 1,4-butanediol divinyl ether (BDDVE), diethylene glycol divinyl ether (DVE-2), triethylene glycol divinyl ether (DVE-3), 1,4-cyclohexanedimethanol divinyl ether (CHDM-di);
- hydroxyvinyl compounds, such as hydroxybutyl vinyl ether (HBVE), 1,4-cyclohexanedimethanol monovinyl ether (CHDM-mono);
- other vinyl compounds such as 1,2,4-trivinylcyclohexane (TVCH).

Examples of other vinyl monomers are 1,1-diester-1-alkenes (for example methylene malonates), 1,1-diketo-1-alkenes, 1-ester-1-keto-1-alkenes and/or icatonates (such as the ones described in WO 2018/219729).

The curable composition of the invention may comprise from 0.1 to 20%, and preferably from 0.1 to 10%, by weight of the photosensitive composition based on the total weight of the ethylenically unsaturated compound(s). For example, the curable composition of the invention may comprise from 0.1 to 1%; or from 1 to 2%; or from 2 to 4%; or from 4 to 6%; or from 6 to 8%; or from 8 to 10%; or from 10 to 12%; or from 12 to 14%; or from 14 to 16%; or from 16 to 18%; or from 18 to 20% by weight of the photosensitive composition based on the total weight of the ethylenically unsaturated compound(s).

In a preferred embodiment, the photocurable composition comprises or consists of:

- 0.01 to 10%, in particular 0.05 to 5%, more particularly 0.1 to 2%, of photoinitiator component;
- 0.01 to 10%, in particular 0.05 to 5%, more particularly 0.1 to 2%, of photoinhibitor component;
- 0.01 to 10%, in particular 0.05 to 5%, more particularly 0.1 to 2%, of photosensitizer component; and
- 0.1 to 20%, in particular 1 to 10%, more particularly 2 to 5%, of chain transfer agent component;

wherein the % are % by weight based on the total weight of the ethylenically unsaturated compound(s). The total amount of photoinitiator component, photoinhibitor component, photosensitizer component, chain transfer agent component and ethylenically unsaturated compound(s) may represent 100% of the weight of the photocurable composition.

In a particularly preferred embodiment, the photocurable composition comprises or consists of:

- 0.01 to 10%, in particular 0.05 to 5%, more particularly 0.1 to 2%, of total phosphine oxide;
- 0.01 to 10%, in particular 0.05 to 5%, more particularly 0.1 to 2%, of total hexaarylbiimidazole;
- 0.01 to 10%, in particular 0.05 to 5%, more particularly 0.1 to 2%, of total aryl ketone; and
- 0.1 to 20%, in particular 1 to 10%, more particularly 2 to 5%, of total thiocarbonylthio;

wherein the % are % by weight based on the total weight of the ethylenically unsaturated compound(s). The total amount of phosphine oxide, hexaarylbiimidazole, aryl ketone, thiocarbonylthio and ethylenically unsaturated compound(s) may represent 100% of the weight of the photocurable composition.

The curable composition according to the invention may also comprise a cationic photoinitiator and a cationically polymerizable compound.

When the composition comprises a cationic photoinitiator and a cationically polymerizable compound, the composition may be a hybrid free-radical/cationic composition, i.e. a composition that is cured by free radical polymerization and cationic polymerization.

The term "cationically polymerizable compound" means a compound comprising a polymerizing functional group which polymerizes via a cationic mechanism, for example a heterocyclic group or a carbon-carbon double bond substituted with an electrodonating group. In a cationic polymerization mechanism, a cationic initiator transfers charge to the cationically polymerizable compound which then becomes reactive and leads to chain growth by reaction with another cationically polymerizable compound.

The cationically polymerizable compound may be selected from epoxy-functionalized compounds, oxetanes, oxolanes, cyclic acetals, cyclic lactones, thiiranes, thiethanes, spiro orthoesters, ethylenically unsaturated compounds other than (meth)acrylates, derivatives thereof and mixtures thereof.

In a preferred embodiment, the cationically polymerizable compound may be selected from epoxy-functionalized compounds, oxetanes and mixtures thereof, in particular aromatic epoxy-functionalized compounds, cycloaliphatic epoxy-functionalized compounds, oxetanes and mixtures thereof.

The curable composition of the invention may comprise 10 to 80%, in particular 15 to 75%, more particularly 20 to 70%, by weight of cationically polymerizable compound based on the total weight of the curable composition.

Suitable cationic photoinitiators include any type of photoinitiator that, upon exposure to radiation such as actinic radiation, forms cations (e.g., Bronsted or Lewis acids) that initiate the reaction of the cationically polymerizable compound. For example, a cationic photoinitiator may be comprised of a cationic portion and an anionic portion. The cationic portion of the photoinitiator molecule can be responsible for the absorption of UV radiation while the anionic portion of the molecule becomes a strong acid after UV absorption.

In particular, the cationic photoinitiator may be selected from onium salts with anions of weak nucleophilicity, such as halonium salts or sulfonium salts (e.g., triarylsulfonium salts such as triarylsulfonium hexafluoroantimonate salts); sulfoxonium salts; diazonium salts; metallocene salts; and mixtures thereof.

The curable composition of the invention may comprise from 0% to 5%, in particular 0.1 % to 4%, more particularly 0.5 to 4%, of cationic photoinitiator by weight based on the total weight of the curable composition.

The curable composition may also comprise one or more thiol-ene polymerizable compounds, such as polythiols.

The curable composition according to the invention may also comprise one or more additives. In particular, the additive may be selected from foam inhibitors, flow or leveling agents, colorants, pigments, dispersants (wetting agents, surfactants), slip additives, fillers, thixotropic agents, matting agents, impact modifiers, waxes, mixtures thereof, and any other additives conventionally used in the coating, sealant, adhesive, molding, 3D printing or ink arts.

Advantageously, the curable compositions of the present invention may be formulated to be solvent-free, i.e., free of any non-reactive volatile substances (substances having a boiling point at atmospheric pressure of 150°C or less). For example, the curable compositions of the present invention may contain little or no non-reactive solvent, e.g., less than 10% or less than 5% or less than 1% or even 0% non-reactive solvent, based on the total weight of the curable composition. As used herein, the term non-reactive solvent means a solvent that does not react when exposed to the actinic radiation used to cure the curable compositions described herein.

According to other advantageous embodiments of the invention, the curable composition is formulated to be useable as a one component or one part system. That is, the curable composition may be cured directly without being combined with another component or second part prior to being cured.

In preferred embodiments of the invention, the curable composition is a liquid at 25°C. In various embodiments of the invention, the curable compositions described herein are formulated to have a viscosity of less than 10,000 mPa.s, or less than 5,000 mPa.s, or less than 4,000 mPa.s, or less than 3,000 mPa.s, or less than 2,500 mPa.s, or less than 2,000 mPa.s, or less than 1,500 mPa.s, or less than 1,000 mPa.s, or even less than 500 mPa.s, as measured at 25°C using a Brookfield viscometer, model DV-II, using a 27 spindle (with the spindle speed varying typically between 20 and 200 rpm, depending on viscosity). In advantageous embodiments of the invention, the viscosity of the curable composition is from 200 to 5,000 mPa.s, or from 200 to 2,000 mPa.s, or from 200 to 1,500 mPa.s, or from 200 to 1,000 mPa.s at 25°C. Relatively high viscosities can provide satisfactory performance in applications where the curable composition is heated above 25°C, such as in three-dimensional printing operations or the like which employ machines having heated resin vats.

The curable compositions described herein may be compositions that are to be subjected to curing by means of free radical polymerization, cationic polymerization or other types of polymerization. In particular embodiments, the curable compositions are photocured (i.e., cured by exposure to actinic radiation such as light, in particular UV, near-UV, visible, infrared or near-infrared light).

The composition according to the invention can in particular be an ink, coating, sealant, adhesive, molding or inking plate composition or a composition for 3D printing.

According to preferred embodiments, the composition according to the invention is a composition for 3D printing.
The composition according to the invention can in particular be used to obtain a cured object and a 3D-printed object according to the processes described below.

Method for producing a cured product and a 3D object

The process for producing a cured product comprises the curing of the curable composition according to the invention. In particular, the composition can be at least partly cured by exposing the curable composition to light, in particular UV, near-UV, visible, infrared or near-infrared light.
The curable composition may be cured by using a single light source. Accordingly, the curable composition is preferably not cured by using a first light source to provide a first wavelength and/or intensity of light; and a second light source to provide a second wavelength and/or intensity of light. In particular, the curable composition may be irradiated at a single wavelength and/or intensity of light. Accordingly, the curable composition is preferably not cured by irradiating the curable composition with a first wavelength and/or intensity of light; and irradiating the curable composition with a second wavelength and/or intensity of light.
The wavelength used to cure the curable composition may be from 300 to 1000 nm, or from 300 to 450 nm, or from 350 to 420 nm, or from 360 to 410 nm. Preferably, the curable composition is only cured by exposure to UV light, i.e. a light having a wavelength of approximately 300-450 nm. Even more preferably, the curable composition is not exposed to blue light, i.e. a light having a wavelength in the range of approximately 450-495 nm.
The composition can be applied to a substrate or poured into a mould before being cured.
The cured product obtained can be an ink, a coating, a sealant, an adhesive, a moulded material, an inking plate or a 3D object. In particular, the cured product can be a 3D object.
The 3D object can in particular be obtained with a process comprising the printing of a 3D object using the composition according to the invention. The process can in particular be a process for continuous or layer-by-layer printing of a 3D object.
The process according to the invention can be carried out in most 3D printing techniques. The process can in particular be a tank (otherwise called vat) or inkjet 3D printing process.
The process can in particular be a 3D printing process in which the composition according to the invention is contained in a tank and selectively cured (either in a plane or in space) by light-activated polymerization. This process is in particular described in standard ISO 52900 (2015). This process includes the various selective polymerization techniques induced by scanning with a light beam (stereolithography - SLA), projection of light images (Digital light processing - DLP) or exposure to light patterns derived from an LCD screen (liquid crystal device - LCD sometimes also referred to as masked stereolithography - MSLA) or any other process which exposes the resin to a light of which the wavelength induces the triggering of polymerization at a very precise site in the tank and limited solely to this site.
Alternatively, the process can be a 3D printing process in which the composition according to the invention is projected in drop form or deposited in the form of a ribbon, before being cured under the effect of radiation. The composition can be projected onto a support, onto the prior layers or onto a layer of powdery substrate.
A *"layer-by-layer"* 3D printing process comprises the following steps:

a) depositing, on a surface, a first layer of curable composition according to the invention,
b) curing the first layer, at least partially, in order to obtain a first cured layer,
c) depositing, on the first cured layer, a second layer of curable composition according to the invention,
d) curing the second layer, at least partially, in order to obtain a second cured layer, which is stuck to the first cured layer; and
e) repeating steps c) and d) the number of times necessary in order to obtain the 3D object.

The curing routes which can be used are those already described above with a particular preference for the techniques for cured by irradiation with light (in particular UV, near-UV, visible, infrared or near-infrared light) in the presence of a photoinitiator.
The curable composition according to the invention can also be used in processes for the production of 3D objects according to a continuous process also known as a CLIP (Continuous Liquid Interface (or Interphase) Product (or Printing)) method or process. This type of process is described in WO 2014/126830, WO 2014/126834 and WO 2014/126837 and in Tumbleston et al., "Continuous Liquid Interface Production of 3D Objects", Science, Vol. 347, Issue 6228, pp. 1349-1352 (March 20, 2015).
The CLIP process proceeds by projection of a film or of a continuous sequence of images by actinic radiation, for example UV radiation, which images can be generated, for example, by a digital imaging unit, through a window transparent to actinic radiation and permeable to oxygen (inhibitor), located under a bath of the composition maintained in liquid form. A liquid interface below the (growing) article is maintained by the dead zone created above the window.

The cured solid article is continuously extracted from the bath of composition above the dead zone, which can be regenerated by introducing, into the bath, additional amounts of the composition in order to compensate for the amounts of composition which are cured and incorporated in the growing article.

For example, a process for printing a 3D object using the composition according to the invention can comprise the following steps:

a) providing a support (or print platen) and an optically transparent element having a construction surface, the support and the construction surface defining, between them, a construction region,
b) filling the construction region with the curable composition according to the invention,
c) continuously or intermittently irradiating the construction region with actinic radiation, in order to form, starting from the curable composition, a cured composition, and
d) continuously or intermittently, moving said support away from the construction surface in order to form the 3D object with the cured composition.

More particularly, the continuous printing process (CLIP type) can comprise the following steps:

a) providing a support (or print platen) and a stationary construction window, the construction window comprising a semipermeable element, said semipermeable element comprising a construction surface and a feed surface separate from the construction surface, the construction surface and the support defining, between them, a construction region, the feed surface being in liquid contact with a polymerization inhibitor,
b) then and at the same time and/or sequentially, filling the construction region with a curable composition according to the invention, said composition being in contact with the print platen,
c) irradiating the construction region through the construction window in order to produce a solid polymerized region in the construction region with a remaining layer of liquid film consisting of the composition, formed between the solid polymerized region and the construction window, the polymerization of the liquid film being inhibited by the polymerization inhibitor; and
d) moving the print platen, to which the polymerized region is stuck, away from the construction surface of the stationary window in order to create a construction region between the polymerized region and the stationary construction window.

Generally, this process includes a step e) of repeating and/or continuing steps b) to d) in order to subsequently produce a polymerized region stuck to a region polymerized previously, until the continuous or repeated deposition of polymerized regions stuck to one another forms the targeted 3D object.

The cured products and 3D objects obtained with the processes according to the invention are described below.

## Examples

The following examples illustrate the invention without limiting it.

### Example 1

In this example:

- diphenyl(2,4,6-trimethylbenzoyl)phosphine oxide (SpeedCure TPO) is the photoinitiator;
- 2-(2-chlorophenyl)-1-[2-(2-chlorophenyl)-4,5-diphenyl-2H-imidazol-2-yl]-4,5-diphenyl-1H-imidazole (BCIM) is the photoinhibitor (HABI), and
- 4,4'-bis(diethylamino)-benzophenone (SpeedCure EMK) is the photosensitizer

The above components were diluted in methanol.

The ratios illustrated in the table below are weight ratios relative to the weight of the methanol solution.

| Photosensitive compositions | TPO (wt%) | BCIM (wt%) | EMK (wt%) |
|---|---|---|---|
| A | 2 | 0.25 | 0.1 |
| B | 2 | - | - |
| C | 2 | - | 0.1 |

(continued)

| Photosensitive compositions | TPO (wt%) | BCIM (wt%) | EMK (wt%) |
|---|---|---|---|
| D | - | 0.25 | 0.1 |
| E | - | 0.25 | - |

The absorption coefficients ε (also known as absorptivity) were determined experimentally via UV/Vis spectroscopy. To do this, the UV-Vis absorbance of each sample was taken with a Perkin-Elmer Model Lambda 365 spectrophotometer using a 1.0 cm path of cuvette quartz cell in accordance with ASTM E169-04, and scanning the spectrum over the wavelength range of 500 to 300 nm. ε values was calculated from absorbance data. The measuring cell was filled at a concentration low enough to ensure that the observed absorbance did not exceed 1.0 in the range of the spectrum for which absorbance values were desired. Accordingly, individual components were evaluated by dissolving the following concentrations in 100 mL of Methanol (MeOH):

- Speedcure TPO solution in Methanol: 50 mg/100 mL or 0.0632% by weight.
- Speedcure EMK solution in Methanol: 0.791 mg/100 mL or 0.001% by weight.
- Speedcure BCIM solution in Methanol: 30 mg/100 mL or 0.0379% by weight.

Absorptivity ε at each wavelength from 300 nm to 500 nm for Speedcure TPO, Speedcure EMK and Speedcure BCIM was then recorded and used in the calculation using the below formula for determining absorbance as described below.

Overall absorbance values of each wavelength were calculated by adding the values for the relevant added light absorbing components as measured above and plotted absorbance from 300 nm to 500 nm in **figure 1.**

For example, absorbance value at 385 nm for Composition A, was determined as follows:

$$A_{385nm} = C_{TPO} \times \varepsilon_{TPO} \times L + C_{EMK} \times \varepsilon_{EMK} \times L + C_{BCIM} \times \varepsilon_{BCIM} \times L$$

wherein:

C is the molar concentration of the respective component of the composition being evaluated;
ε is the absorption coefficient (also known as absorptivity) of the respective component of the composition being evaluated at the wavelength 385 nm;
L is the thickness of the cuvette used to take the UV spectrum measurement.

As illustrated in **figure 1,** the photosensitive composition A presents a maximum absorption at a wavelength which is close to the beam having a wavelength of 385 nm.

In addition, as displayed in **figure 1,** the photoinhibitor (composition E) had no absorbance and the photoinitiator (composition B) had low absorbance under 385 nm LED. However, the composition comprising both the photoinhibitor and the photosensitizer (composition D), has the same absorbance as that of the composition comprising both the photosensitizer and the photoinitiator (composition C). Both of these compositions exhibit a strong and broad overlap with 385 nm LED.

Example 2

In this example, four photosensitive compositions were mixed with ethylenically unsaturated monomers to form the curable compositions F to I (composition F being according to the invention and compositions G to I being comparative compositions).

In this example:

- diphenyl(2,4,6-trimethylbenzoyl)phosphine oxide (TPO) is the photoinitiator,
- 2-(2-chlorophenyl)-1-[2-(2-chlorophenyl)-4,5-diphenyl-2H-imidazol-2-yl]-4,5-diphenyl-1H-imidazole (BCIM) is the photoinhibitor (HABI),
- 4,4'-bis(diethylamino)-benzophenone (EMK) is the photosensitizer, and
- 2-mercaptobenzothiazole is the chain transfer agent.

In addition, the ethylenically unsaturated monomers used in this example are an aliphatic urethane acrylate oligomer (CN991) and a cyclic trimethylol formal acrylate (SR531).

The compositions F to I were mixed on a FlackTek Speedmixer and warmed as needed to fully dissolve all solids.

The ratios illustrated in the table below are weight ratios relative to the total weight of the ethylenically unsaturated monomers.

| Curable compositions | SR531 (wt%) | CN991 (wt%) | TPO (wt%) | BCIM (wt%) | EMK (wt%) | 2-mercaptobenzothiazole (wt%) |
|---|---|---|---|---|---|---|
| F | 50 | 50 | 2 | 0.25 | 0.1 | 2 |
| G | 50 | 50 | 2 | 0 | 0.1 | 2 |
| H | 50 | 50 | 2 | 0.25 | 0.1 | 0 |
| I | 50 | 50 | 2 | 0 | 0.1 | 0 |

<u>3D-printed objects were prepared by the following way:</u>

1) An STL file (a computer aided design file used to generate 3-dimensional parts for 3D printing) that has holes of varying diameter was imported. The holes had the following diameters:

Hole 13: 2.38 mm
Hole 14: 2.57 mm

2) For this STL file, a 50 μm layer thickness in the slicing software was used.
3) The STL file was then imported to the printer slicing software.
4) The part containing holes of varying diameter (XY resolution diagnostic part) was placed in the center of the 385 nm EnvisionOne 3D printer XY build area.
5) The part containing holes of varying diameter (XY resolution diagnostic part) was placed on the surface, without the use of any support structures, rafts, or base plates.
6) The standard range and burn in range UV exposure time were assigned to the print
7) The other settings were minimized (such elevator waiting times).

<u>The printer was prepared following the procedure below:</u>

1) The build platform was removed.
2) The vat was installed.
3) The curable compositions were placed on the vat.

<u>Printing of the XY resolution diagnostic part:</u>

1) The part (33 mm x 33 m x 1.02 mm) was printed from the compositions F to I by using 385 nm EnvisionOne at 0.5 seconds per layer.
2) No build platform was used. This makes it possible for the material to cure past set layer thicknesses of the build platform, allowing for thicker parts to be printed, which can help identify cure bleed in the XY direction.
3) 20 layers in Z direction with a layer thickness of 50 μm were printed.
4) Approximately 50-60 mJ/cm$^2$ total energy dosage. The energy dosage is a function of the irradiance of the UV light source multiplied by the time of exposure. Each solid area of the slice file receives a set amount of energy dosage. The total energy dosage is approximately equal to the energy dosage per layer multiplied by the number of layers.
5) The printed parts were carefully removed and cleaned with Wypall paper towels.
6) The printed parts were then placed on a microscope glass so as to examine the holes.

7) Pictures of each hole were taken with the microscope.
8) The pictures were studied so as to define the parts exhibiting the least XY resolution bleed. In order to explain *"XY resolution bleed"* or *"cure bleed":* a computer-aided design file is converted to an STL file, which contains information about the geometry of a part file. This information is used by the 3D printer during printing, and if the printed part has open holes with diameters smaller than the computer-aided design file, the material is exhibiting cure bleed. When the material exhibits low or no cure bleed, the parts will match the computer-aided design file closely, with there being minimal cured material outside of the geometry that is being printed.

As illustrated in the table below the composition according to the invention (F) leads to a product with higher resolution when holes having a diameter of 2.38 mm and 2.57 mm are formed. On the contrary, the comparative compositions (G to I) lead to products with a lower resolution and thus a lower quality.

| Compositions | F | G | H | I |
|---|---|---|---|---|
| Resolution (hole=2.38 mm) | high | low | low | low |
| Resolution (hole=2.57 mm) | high | low | low | low |

As illustrated in **figure 2,** the composition according to the invention (F) leads to a product with higher resolution when holes having a diameter of 2.38 mm (upper part of **figure 2**) and 2.57 mm (lower part of **figure 2**) are formed. On the contrary, the comparative compositions (G to I) lead to products with a lower resolution and thus a lower quality.

Example 3

In this example, photosensitive compositions were mixed with ethylenically unsaturated monomers to form the curable compositions J and K. The components of each composition are illustrated in the table below and are as detailed above.

In addition, the ethylenically unsaturated monomers used in this example are an aliphatic urethane acrylate oligomer (CN991) and a cyclic trimethylol formal acrylate (SR531).

The compositions J and K were mixed on a FlackTek Speedmixer and warmed as needed to fully dissolve all solids.

Calculation of critical energy (Ec) and depth penetration (Dp)

Working curves were measured using the method below to calculate the Ec and Dp. By *"working-curves"* is meant a set of printed thin films that each receive a specified energy dosage, which are then measured with a micrometer to determine a correlation between the energy dosage and the cure depth of the thin films. A semilog plot of the cure depth versus the energy dosage should provide a linear plot. The slope of the linear line is the penetration depth Dp, and the intercept that corresponds to a cure depth of zero is the critical exposure Ec.

Working curves and 3D printing were done on an EnvisionOne 3D printer from EnvisionTec with a 385 nm light source. The printing files and the printer preparation are same as above.

Print the working-curve parts:

1) The working-curve print file was initiated.
2) Once the print is complete, the part from the bottom of the vat surface was carefully peeled off.
3) The part was cleaned with IPA (isopropyl alcohol), TPM (tripropylene glycol monomethyl ether), acetone, or other solvent.
4) 2 to 3 working-curves were printed for each composition.

Measuring the cure depths for corresponding energy dosages

1) A dial indicator with a comparator stand was used to measure the cure depths of all parts.
2) The energy dosages were determined as follows:

$$\text{Energy dosage (mJ/cm}^2\text{) = irradiance (mW/cm}^2\text{) x time (seconds).}$$

The irradiance (or projector intensity) was 5.6 mW/$cm^2$.

| Time of exposure(s) | Exposure (mJ/$cm^2$) | Thickness (mils) |
|---|---|---|
| 1 | 5.6 | 2.76 |
| 2 | 11.2 | 4.61 |
| 3 | 16.7 | 5.55 |
| 4 | 22.3 | 6.26 |
| 5 | 27.9 | 6.77 |
| 6 | 33.5 | 7.13 |
| 7 | 39.1 | 7.60 |
| 8 | 44.6 | 7.91 |
| 9 | 50.2 | 8.11 |

<u>Determining critical exposure, penetration depth, and print parameters</u>

1) The Jacobs working-curve equation, described in P.F. Jacobs, Fundamentals of stereolithography, Proc. Solid Free. Fabr. Symp. (1992) 87-89, was used to determine critical exposure, Ec (mJ/$cm^2$), and penetration depth, Dp (mils).

a.

$$Cd = Dp \times \ln(E_{max}/E)$$

b. Wherein :

i. $C_d$ = measured cure depths (mils)
ii. Emax = energy dosages (mJ/$cm^2$)

c. Plot $C_d$ (mils) vs. In($E_{max}$) to get working cure. The slope of the plot corresponds to the penetration depth and the $E_{max}$ point that corresponds to $C_d$ = 0 is the critical exposure.

2) The measured cure depths and corresponding exposure times were used to determine the optimal print parameters. Target an exposure time that achieves a cure depth 2-4 x the layer thickness to print with.

Compositions J and K are according to the invention.

The weight ratio of the TPO photoinitiator was modified from one composition to another.

| Curable compositions | J | K |
|---|---|---|
| SR531 (wt%) | 50 | 50 |
| CN991 (wt%) | 50 | 50 |
| TPO (wt%) | 0.05 | 0.1 |
| BCIM (wt%) | 0.25 | 0.25 |
| EMK (wt%) | 0.1 | 0.1 |
| 2-mercaptobenzothiazole (wt%) | 2 | 2 |

(continued)

| Curable compositions | J | K |
|---|---|---|
| Exposure time per layer-385 nm (s) | 4 | 4 |
| Dp (mils) | 3.31 | 3.48 |
| Ec (mJ/cm$^2$) | 42.02 | 38.27 |
| Resolution | high | high |

The holes were formed as detailed above but with variable exposure times per layer as illustrated in the table above. As illustrated in the table above, it is clear that the compositions J and K make it possible to obtain a product with high resolution and with a relatively low Ec and a relatively high Dp when a hole having a diameter of 0.37 mm is formed.

## Claims

**1.** A photosensitive composition comprising:

- a photoinitiator component;
- a photoinhibitor component;
- a photosensitizer component; and
- a chain transfer agent component.

**2.** The photosensitive composition according to claim 1, wherein the mixture of the photoinitiator component and the photosensitizer component has a absorption maximum at substantially the same wavelength as that of the mixture of the photoinhibitor component and the photosensitizer component, in particular said wavelength is in the range of from 300 to 1000 nm, or from 320 to 450 nm, or from 350 to 420 nm, or from 360 to 410 nm.

**3.** The photosensitive composition according to claim 1 or 2, wherein the photoinitiator component comprises a photoinitiator having Norrish Type I activity, in particular a phosphine oxide, more particularly a mono-acyl phosphine oxide or a di-acyl phosphine oxide.

**4.** The photosensitive composition according to any one of claims 1 to 3, wherein the photoinitiator component comprises a compound chosen from (2,4,6-trimethylbenzoyl)diphenylphosphine oxide, bis(2,4,6-trimethyl benzoyl)phenylphosphine oxide, ethyl (2,4,6-trimethylbenzoyl)phenyl phosphinate, ethyl (3-benzoyl-2,4,6-trimethylbenzoyl)phenyl phosphinate and combinations thereof; in particular (2,4,6-trimethylbenzoyl) diphenylphosphine oxide.

**5.** The photosensitive composition according to any one of claims 1 to 4, wherein the photoinhibitor component comprises a hexaarylbiimidazole, in particular a non-bridged hexaarylbiimidazole.

**6.** The photosensitive composition according to any one of claims 1 to 5, wherein the photoinhibitor component comprises 2-(2-chlorophenyl)-1-[2-(2-chlorophenyl)-4,5-diphenyl-2H-imidazol-2-yl]-4,5-diphenyl-1H-imidazole.

**7.** The photosensitive composition according to any one of claims 1 to 6, wherein the photosensitizer component comprises a compound having at least one aryl ketone function.

**8.** The photosensitive composition according to any one of claims 1 to 7, wherein the photosensitizer component comprises 4,4'-bis(diethylamino)-benzophenone.

**9.** The photosensitive composition according to any one of claims 1 to 8, wherein the chain transfer agent component comprises a compound chosen from $\alpha$-amino acids, compounds comprising at least one sulfur atom and mixtures thereof.

**10.** The photosensitive composition according to any one of claims 1 to 9, wherein the chain transfer agent component comprises a compound chosen from a thiol, a thioether, a disulfide, a thiocarbamate, a thiocarbonylthio and combinations thereof, in particular a thiol, a thiocarbonylthio and combinations thereof, more particularly a thiocarbonylthio, even more particularly 2-mercaptobenzothiazole.

**11.** The photosensitive composition according to any one of claims 1 to 10, wherein the photoinitiator component is present at an amount from 0.01 to 60%, in particular from 0.1 to 50%, more particularly from 1 to 5% by weight relative to the total weight of the composition; and/or the photoinhibitor component is present at an amount from 0.01 to 30%, in particular from 0.1 to 20%, more particularly from 1 to 10%, by weight relative to the total weight of the composition; and/or the photosensitizer component is present at an amount from 0.01 to 10%, in particular from 0.1 to 10%, more particularly from 1 to 5%, by weight relative to the total weight of the composition; and/or the chain transfer agent component is present at an amount from 0.1 to 90%, in particular from 10 to 85%, more particularly from 40 to 85%, by weight relative to the total weight of the composition.

**12.** A curable composition comprising:

- one or more ethylenically unsaturated compounds; and
- the photosensitive composition according to any claims 1 to 11.

**13.** The curable composition according to claim 12, wherein the photosensitive composition is present at an amount from 0.1 to 20% by weight relative to the total weight of the ethylenically unsaturated compounds.

**14.** The curable composition according to any one of claims 12 to 13, further comprising a cationic photoinitiator and a cationically polymerizable compound.

**15.** The curable composition according to any one of claims 12 to 14, further comprising one or more thiol-ene polymerizable compounds, such as polythiols.

**16.** A method for producing a cured product, **characterized in that** it comprises curing the curable composition according to claims 12 to 15, by irradiating the curable composition.

**17.** The method according to claim 16, wherein the irradiation is carried out with a single light source, in particular with a single wavelength of light, more particularly at a wavelength of from 300 to 1000 nm, or from 320 to 450 nm, or from 350 to 420 nm, or from 360 to 410 nm.

**18.** The method according to claim 16 or 17, **characterized in that** the cured product is a 3D-printed object and method comprises printing a 3D object with the composition according to any one of claims 12 to 15, in particular layer by layer or continuously.

**19.** Use of the photosensitive composition according to any one of claims 1 to 11, for curing an ethylenically unsaturated compound.

**20.** Use of the curable composition according to any one of claims 12 to 15, for obtaining a 3D-printed object.

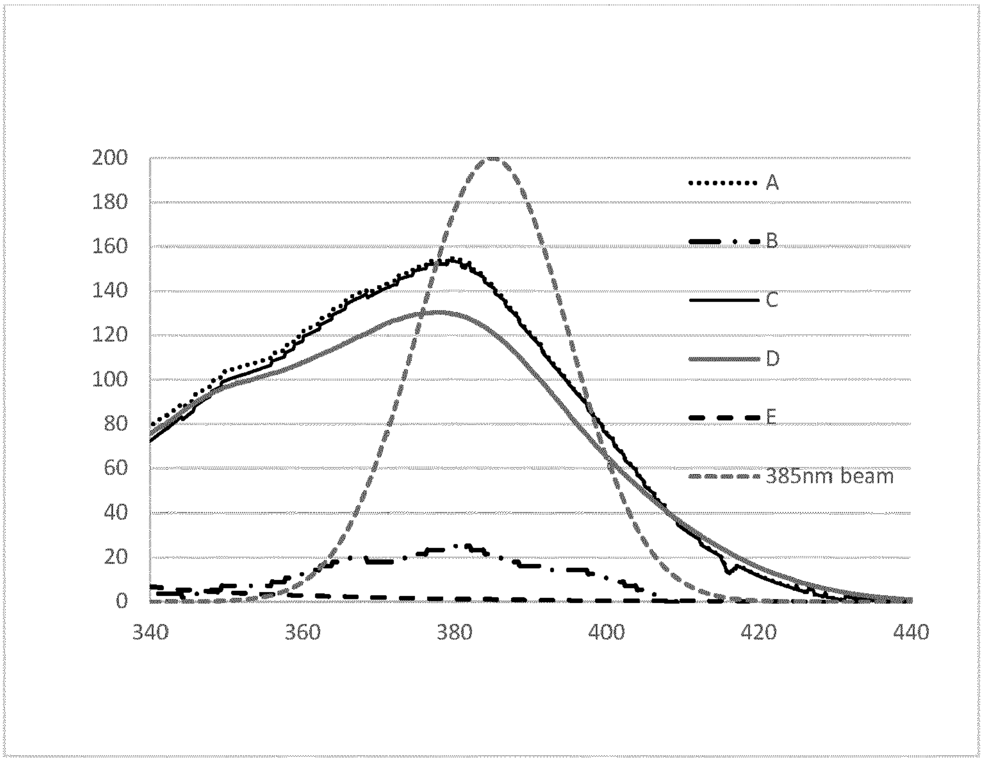
200
180
160
140
120
100
80
60
40
20
0
340
360
380
400
420
440
A
B
C
D
E
385nm beam

Fig. 1

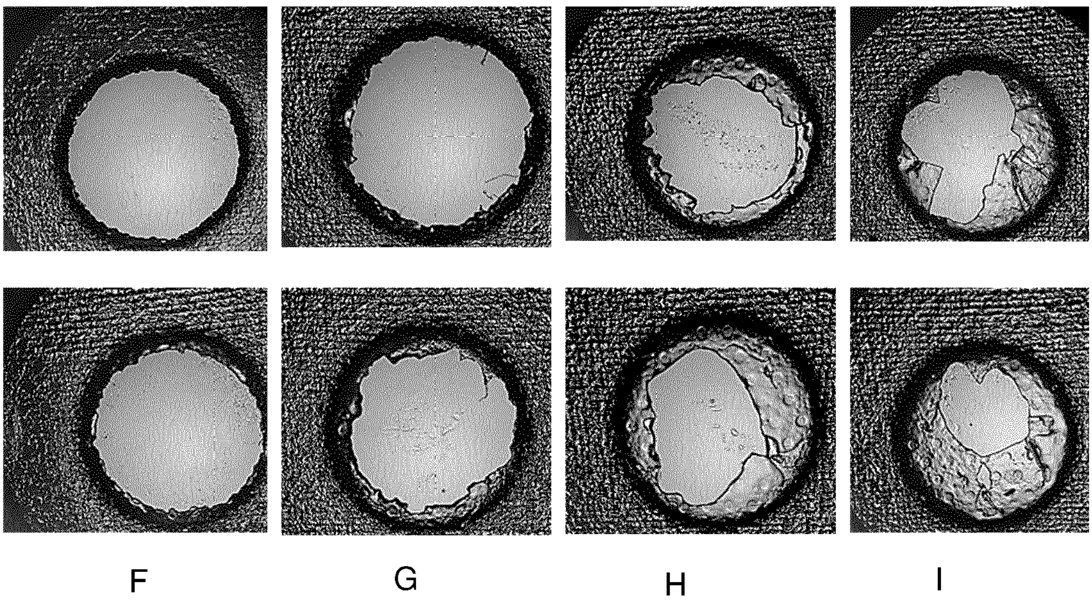
F
G
H
I

Fig. 2

Europäisches Patentamt
European Patent Office
Office européen des brevets

# EUROPEAN SEARCH REPORT

Application Number
EP 21 30 6289

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 561 969 A2 (FUJIFILM CORP [JP]) 27 February 2013 (2013-02-27)<br>* paragraphs [0002], [0005] - [0007], [0110] - [0123], [0142], [0179] - [0196]; claims 1-9; tables 1,2 * | 1-4,7, 9-13, 15-17,19 | INV.<br>B33Y70/00<br>G03F7/00<br>G03F7/029<br>G03F7/031<br>G03F7/038 |
| A | JP 2018 034382 A (FUJI XEROX CO LTD) 8 March 2018 (2018-03-08)<br>* paragraphs [0009] - [0029], [0101] - [0105], [0126] - [0136]; claims 1-9; examples 1-10 * | 1-20 | |
| A | WO 2012/014580 A1 (HITACHI CHEMICAL CO LTD [JP]; IWASHITA KENICHI [JP] ET AL.) 2 February 2012 (2012-02-02)<br>* paragraphs [0090] - [0110]; claims 1-8; examples 1-11 * | 1-20 | |
| A | JP 2018 034383 A (FUJI XEROX CO LTD) 8 March 2018 (2018-03-08)<br>* paragraphs [0097] - [0118]; claims 1-3; examples 1-4 * | 1-20 | TECHNICAL FIELDS SEARCHED (IPC)<br>B33Y<br>G03F |

1 The present search report has been drawn up for all claims

| Place of search | Date of completion of the search | Examiner |
|---|---|---|
| Munich | 4 March 2022 | Eggers, Karin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 21 30 6289

This annex lists the patent family members relating to the patent documents cited in the above-mentioned European search report. The members are as contained in the European Patent Office EDP file on
The European Patent Office is in no way liable for these particulars which are merely given for the purpose of information.

04-03-2022

| Patent document cited in search report | Publication date | Patent family member(s) | Publication date |
|---|---|---|---|
| EP 2561969 A2 | 27-02-2013 | CN 102950950 A | 06-03-2013 |
| | | EP 2561969 A2 | 27-02-2013 |
| | | JP 5613124 B2 | 22-10-2014 |
| | | JP 2013043361 A | 04-03-2013 |
| | | US 2013049267 A1 | 28-02-2013 |
| JP 2018034382 A | 08-03-2018 | JP 6801301 B2 | 16-12-2020 |
| | | JP 2018034382 A | 08-03-2018 |
| WO 2012014580 A1 | 02-02-2012 | CN 102597877 A | 18-07-2012 |
| | | CN 102854750 A | 02-01-2013 |
| | | JP 4849197 B1 | 11-01-2012 |
| | | JP WO2012014580 A1 | 12-09-2013 |
| | | KR 20130095631 A | 28-08-2013 |
| | | TW 201216002 A | 16-04-2012 |
| | | WO 2012014580 A1 | 02-02-2012 |
| JP 2018034383 A | 08-03-2018 | JP 6801302 B2 | 16-12-2020 |
| | | JP 2018034383 A | 08-03-2018 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2019164808 A
- US 20160067921 A
- US 4859551 A
- WO 2018219729 A
- WO 2014126830 A
- WO 2014126834 A
- WO 2014126837 A


### Non-patent literature cited in the description


- **HAYASHI ; MAEDA.** Preparation of a new phototropic substance. *Bull. Chem. Soc. Jpn.,* 1960, vol. 33 (4), 565-66
- **SATOH et al.** Ultrafast laser photolysis study on photodissociation dynamics of a hexaarylbiimidazole derivative. *Chem. Phys. Lett.,* 2007, vol. 448 (4-6), 228-31
- **SATHE et al.** Re-examining the Photomediated Dissociation and Recombination Kinetics of Hexaarylbiimidazoles. *Ind. Eng. Chem. Res.,* 2015, vol. 54 (16), 4203-12
- **TUMBLESTON et al.** Continuous Liquid Interface Production of 3D Objects. *Science,* 20 March 2015, vol. 347 (6228), 1349-1352
- **P.F. JACOBS.** Fundamentals of stereolithography. *Proc. Solid Free. Fabr. Symp.,* 1992, 87-89